# EUROPEAN PATENT APPLICATION

(11) **EP 4 528 404 A1**
(43) Date of publication of application: **26.03.2025**
(21) Application number: 23859071.5
(22) Date of filing: 07.08.2023
(51) Int. Cl.: G05B 19/042, H03K 17/04

(54) **DEVICE CONTROL METHOD, INTELLIGENT SWITCH, AND CONTROL SYSTEM**

(30) Priority: 31.08.2022 CN 202211057141
(71) Applicant: Huawei Technologies Co., Ltd., Shenzhen, Guangdong 518129 (CN)
(72) Inventor: ZHANG, Fan, Shenzhen, Guangdong 518129 (CN); SHI, Huijie, Shenzhen, Guangdong 518129 (CN); WANG, Tao, Shenzhen, Guangdong 518129 (CN)
(74) Representative: Pfenning, Meinig & Partner mbB
(86) International application number: PCT/CN2023/111421
(87) International publication number: WO 2024/046036

(57) **Abstract**

A device control method, a smart switch, and a control system are provided, and are applicable to the field of terminal technologies. The method includes: adjusting, in response to state switching triggered for a smart switch, a relay state of each relay in the smart switch based on an initial correspondence between a device state and a relay state; and if a device state of the electrical device does not change, determining an actual correspondence between the device state and the relay state based on the initial correspondence, and adjusting the relay state of each relay in the smart switch based on the actual correspondence. According to the method, an actual correspondence between a lamp state and a relay state is determined based on lamp states obtained in two times, so that a lamp is controlled based on the actual correspondence. This can reduce time spent in controlling the lamp by using the smart switch, and improve efficiency and accuracy of controlling the lamp by using the smart switch.

## Description

This application claims priority to Chinese Patent Application No. 202211057141.8, filed with the China National Intellectual Property Administration on August 31, 2022 and entitled "DEVICE CONTROL METHOD, SMART SWITCH, AND CONTROL SYSTEM", which is incorporated herein by reference in its entirety.

### TECHNICAL FIELD

This application relates to the field of smart home technologies, and in particular, to a device control method, a smart switch, and a control system.

### BACKGROUND

With continuous development of smart home technologies, a smart switch also emerges accordingly. A smart home device may be connected to the smart switch, so that on/off of the smart home device is controlled by using the smart switch.

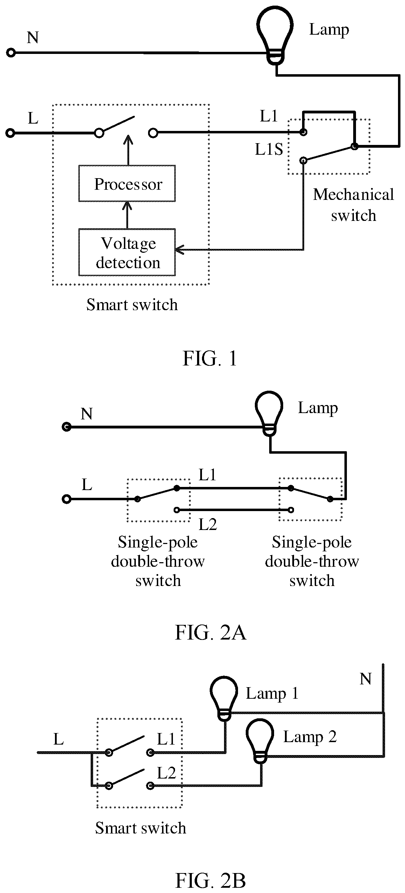

In a conventional technology, for example, a smart switch is connected to a lamp. As shown in FIG. 1, a cable connection of a mechanical switch needs to be adjusted first, so that the smart switch is always in a powered-on state. When a state of the mechanical switch changes, that is, when the mechanical switch is switched between L1 and L1S, the smart switch may determine, by using a voltage detection module, that a potential at the mechanical switch changes, to determine that the state of the mechanical switch changes. Further, the smart switch may be controlled, by using a processor, to be turned on, to control the lamp.

However, there is a specific delay when the smart switch controls on/off of the lamp based on the change of the potential at the mechanical switch.

### SUMMARY

This application provides a device control method, a smart switch, and a control system, to resolve a problem that there is a delay in turning on or off a lamp by using a smart switch in the conventional technology.

To achieve the foregoing objectives, the following technical solutions are used in this application.

According to a first aspect, a device control method is provided, applied to a smart switch, where the smart switch is connected to an electrical device, the smart switch includes a plurality of relays, and the method includes:
adjusting, in response to state switching triggered for the smart switch, a relay state of each relay in the smart switch based on an initial correspondence between a device state and a relay state; and
if a device state of the electrical device does not change, determining an actual correspondence between the device state and the relay state based on the initial correspondence, and
adjusting the relay state of each relay in the smart switch based on the actual correspondence; or
if a device state of the electrical device changes, determining the initial correspondence as an actual correspondence between the device state and the relay state.

The lamp state is obtained, the state of the relay in the smart switch is adjusted based on the triggered state switching action and the initial correspondence between the lamp state and the relay state, and then the lamp state is obtained again. Based on the lamp states obtained in two times, the actual correspondence between the lamp state and the relay state is determined, so that the lamp is controlled based on the actual correspondence. This can reduce time spent in controlling the lamp by using the smart switch, and improve efficiency and accuracy of controlling the lamp by using the smart switch.

In a first possible implementation of the first aspect, before the adjusting, in response to state switching triggered for the smart switch, a relay state of each relay in the smart switch based on an initial correspondence between a device state and a relay state, the method further includes:
after detecting that the smart switch is powered on, obtaining the device state of the electrical device; and
establishing the initial correspondence between the device state and the relay state.

Based on the first possible implementation of the first aspect, in a second possible implementation of the first aspect, the device state is an on state or an off state, and the relay state is a turned-on state or a turned-off state; and
the establishing the initial correspondence between the device state and the relay state includes:
obtaining a preset default state of each relay, where the default state is a turned-on state or a turned-off state;
establishing, based on the device state of the electrical device, a first mapping relationship between the device state and the default state of each relay;
establishing, based on a target state of the electrical device, a second mapping relationship between the target state and a non-default state of each relay, where the non-default state is a relay state opposite to the default state, and the target state is a state that is of the electrical device and that is opposite to the device state; and
obtaining the initial correspondence by combining the first mapping relationship and the second mapping relationship.

After the smart switch is powered on, the device state is obtained, and the initial correspondence between the device state and the relay state is established, so that the relay state can be adjusted based on the initial correspondence. This improves efficiency of adjusting the device state of the electrical device.

In addition, the first mapping relationship and the second mapping relationship are established, and when the initial correspondence needs to be adjusted, the initial correspondence can be adjusted conveniently and quickly based on the first mapping relationship and the second mapping relationship. This can improve efficiency of determining the actual correspondence.

In a third possible implementation of the first aspect, the device state is an on state or an off state, and the relay state is a turned-on state or a turned-off state; and
the determining an actual correspondence between the device state and the relay state based on the initial correspondence includes:
replacing, with a target state of the electrical device, a device state corresponding to a default state of each relay in the initial correspondence, and replacing, with the device state of the electrical device, a target state corresponding to a non-default state of each relay in the initial correspondence, to obtain the actual correspondence, where
the non-default state is a relay state opposite to the default state, and the target state is a state that is of the electrical device and that is opposite to the device state.

Based on any one of the possible implementations of the first aspect, in a fourth possible implementation of the first aspect, the adjusting the relay state of each relay in the smart switch based on the actual correspondence includes:
determining the target state of the electrical device, where the target state is the state that is of the electrical device and that is opposite to the device state;
obtaining, based on the actual correspondence, a plurality of target relay states matching the target state, where each target relay state is in a one-to-one correspondence with each relay; and
adjusting each relay based on each target relay state.

Based on the fourth possible implementation of the first aspect, in a fifth possible implementation of the first aspect, the adjusting each relay based on each target relay state includes:
selecting a preferred relay state from the plurality of target relay states based on the target state, where the preferred relay state is used to adjust the electrical device to switch to the target state;
adjusting, based on the preferred relay state, a preferred relay corresponding to the preferred relay state; and
adjusting a relay other than the preferred relay in the plurality of relays based on a target relay state other than the preferred relay state in the plurality of target relay states.

The preferred relay state and the preferred relay are determined, and the target relay states are adjusted based on the preferred relay state and the preferred relay, so that time spent in switching the device state can be reduced, and efficiency of switching the device state can be improved.

Based on any one of the possible implementations of the first aspect, in a sixth possible implementation of the first aspect, the smart switch and the electrical device are further connected to a mechanical switch, and the method includes:
detecting state switching triggered for the mechanical switch; and
updating the actual correspondence in response to the state switching triggered for the mechanical switch.

The mechanical switch is detected, so that the actual correspondence can be updated in time, to avoid an error in the actual correspondence, and reliability and stability of normal running of the smart switch can be improved.

Based on any one of the possible implementations of the first aspect, in a seventh possible implementation of the first aspect, after the adjusting the relay state of each relay in the smart switch based on the actual correspondence, the method further includes:
detecting again state switching triggered for the mechanical switch or the smart switch; and
adjusting, in response to the state switching triggered for the mechanical switch or the smart switch, the relay state of each relay in the smart switch based on the actual correspondence.

According to a second aspect, a device control apparatus is provided. The apparatus includes:
an adjustment module, configured to adjust, in response to state switching triggered for a smart switch, a relay state of each relay in the smart switch based on an initial correspondence between a device state and a relay state;
a determining module, configured to: if a device state of an electrical device does not change, determine an actual correspondence between the device state and the relay state based on the initial correspondence;
the adjustment module is further configured to adjust the relay state of each relay in the smart switch based on the actual correspondence; and
the determining module is further configured to: if a device state of an electrical device changes, determine the initial correspondence as the actual correspondence between the device state and the relay state.

In a first possible implementation of the second aspect, the apparatus further includes:
an obtaining module, configured to obtain the device state of the electrical device after detecting that the smart switch is powered on; and
an establishment module, configured to establish the initial correspondence between the device state and the relay state.

Based on the first possible implementation of the second aspect, in a second possible implementation of the second aspect, the device state is an on state or an off state, and the relay state is a turned-on state or a turned-off state; and
the establishment module is specifically configured to: obtain a preset default state of each relay, where the default state is a turned-on state or a turned-off state; establish, based on the device state of the electrical device, a first mapping relationship between the device state and the default state of each relay; establish, based on a target state of the electrical device, a second mapping relationship between the target state and a non-default state of each relay, where the non-default state is a relay state opposite to the default state, and the target state is a state that is of the electrical device and that is opposite to the device state; and obtain the initial correspondence by combining the first mapping relationship and the second mapping relationship.

In a third possible implementation of the second aspect, the device state is an on state or an off state, and the relay state is a turned-on state or a turned-off state; and
the determining module is specifically configured to: replace a device state corresponding to a default state of each relay in the initial correspondence with a target state of the electrical device, and replace a target state corresponding to a non-default state of each relay in the initial correspondence with the device state of the electrical device, to obtain the actual correspondence, where
the non-default state is a relay state opposite to the default state, and the target state is a state that is of the electrical device and that is opposite to the device state.

Based on any one of the possible implementations of the second aspect, in a fourth possible implementation of the second aspect, the adjustment module is specifically configured to: determine the target state of the electrical device, where the target state is the state that is of the electrical device and that is opposite to the device state; obtain, based on the actual correspondence, a plurality of target relay states matching the target state, where each target relay state is in a one-to-one correspondence with each relay; and adjust each relay based on each target relay state.

Based on the fourth possible implementation of the second aspect, in a fifth possible implementation of the second aspect, the adjustment module is further specifically configured to: select a preferred relay state from the plurality of target relay states based on the target state, where the preferred relay state is used to adjust the electrical device to switch to the target state; adjust, based on the preferred relay state, a preferred relay corresponding to the preferred relay state; and adjust a relay other than the preferred relay in the plurality of relays based on a target relay state other than the preferred relay state in the plurality of target relay states.

Based on any one of the possible implementations of the second aspect, in a sixth possible implementation of the second aspect, the smart switch and the electrical device are further connected to a mechanical switch, and the apparatus further includes:
a first detection module, configured to detect state switching triggered for the mechanical switch; and
an update module, configured to update the actual correspondence in response to the state switching triggered for the mechanical switch.

Based on any one of the possible implementations of the second aspect, in a seventh possible implementation of the second aspect, the apparatus further includes:
a second detection module, configured to detect again state switching triggered for the mechanical switch or the smart switch; and
the adjustment module, further configured to adjust, in response to the state switching triggered for the mechanical switch or the smart switch, the relay state of each relay in the smart switch based on the actual correspondence.

According to a third aspect, a smart switch is provided, where the smart switch includes: a processor, a device state determining module, a plurality of magnetic latching relays, an on-state power obtaining module, and an off-state power obtaining module;
the processor is connected to the device state determining module, the on-state power obtaining module, and the off-state power obtaining module, the plurality of magnetic latching relays are all connected to the on-state power obtaining module and the off-state power obtaining module, the device state determining module is further connected to a voltage collection point, and the voltage collection point is a potential between the on-state power obtaining module and the plurality of magnetic latching relays; and
the device state determining module is configured to determine a device state of an electrical device connected to the smart switch, and the processor is configured to adjust relay states of the plurality of magnetic latching relays based on the device state determined by the device state determining module.

In a first possible implementation of the third aspect, the device state determining module includes: a switch device, an energy storage capacitor, a voltage divider resistor, and a pull-up resistor; and
the voltage divider resistor is connected in series between a control end of the switch device and the voltage collection point, the pull-up resistor is connected in series between a first end of the switch device and a power supply voltage, the energy storage capacitor is connected in series between the voltage collection point and a ground potential, the first end of the switch device is connected to the processor, and a second end of the switch device is connected to the ground potential.

In a second possible implementation of the third aspect, the device state determining module includes: a comparison module, an energy storage capacitor, and voltage divider resistors;
a positive input end of the comparison module is connected to a reference voltage, a negative input end of the comparison module is connected to the voltage collection point, and an output end of the comparison module is connected to the processor;
the voltage divider resistors are respectively connected in series between the positive input end of the comparison module and the reference voltage and between the negative input end of the comparison module and the voltage collection point; and
the energy storage capacitor is connected in series between the voltage collection point and a ground potential.

According to a fourth aspect, a control system is provided, where the control system includes: an electrical device, a smart switch, and a mechanical switch; and
the electrical device is connected in series to the smart switch and the mechanical switch, the mechanical switch is configured to adjust a device state of the electrical device, and the smart switch is configured to adjust the device state of the electrical device according to the device control method according to any implementation of the first aspect.

According to a fifth aspect, a computer-readable storage medium is provided. The computer-readable storage medium stores a computer program. When the computer program is executed by a processor, the device control method according to any implementation of the first aspect is implemented.

According to a sixth aspect, a chip system is provided. The chip system includes a memory and a processor. The processor executes a computer program stored in the memory, to implement the device control method according to any implementation of the first aspect.

It may be understood that for beneficial effects of the second aspect to the sixth aspect, refer to related descriptions in the first aspect. Details are not described herein again.

### BRIEF DESCRIPTION OF DRAWINGS

FIG. 1 is a diagram of a scenario of a smart switch according to a conventional technology;
FIG. 2A is a schematic of a circuit of a conventional control system according to an embodiment of this application;
FIG. 2B is a schematic of a circuit of a smart control system according to an embodiment of this application;
FIG. 2C is a schematic of a circuit of a smart control system according to an embodiment of this application;
FIG. 3 is a diagram of application of a single-live-wire smart switch;
FIG. 4A is a diagram of a two-single-pole-switch scenario based on a single-live-wire smart switch according to an embodiment of this application;
FIG. 4B is diagram of another single-pole double-throw switch scenario based on a single-live-wire smart switch according to an embodiment of this application;
FIG. 4C is a diagram of an architecture of a circuit of a lamp state determining module according to an embodiment of this application;
FIG. 4D is a diagram of an architecture of a circuit of another lamp state determining module according to an embodiment of this application;
FIG. 5 is a schematic flowchart of a device control method according to an embodiment of this application; and
FIG. 6 is a block diagram of a structure of a device control apparatus according to an embodiment of this application.

### DESCRIPTION OF EMBODIMENTS

In the following descriptions, for illustration instead of limitation, specific details such as a particular system structure and a particular technology are provided for thorough understanding of embodiments of this application. However, a person skilled in the art should know that this application may also be implemented in other embodiments without these specific details. In other cases, detailed descriptions of well-known switch connection methods, switch state switching methods, device state switching methods, and electronic devices are omitted, to avoid unnecessary details that interfere with description of this application.

Terms used in the following embodiments are merely intended to describe specific embodiments, but are not intended to limit this application. Terms "a", "the", "the foregoing", and "this" of singular forms used in this specification and the appended claims of this application are intended to further include expressions such as "one or more", unless otherwise specified in the context clearly.

With continuous development of science and technology, conventional electrical devices gradually develop toward intelligence, and a growing number of smart home devices are formed. Accordingly, conventional switches (such as mechanical switches) that control electrical devices gradually develop into smart switches. In a smart home scenario, a smart switch may be connected to a smart home device, and the smart home device is controlled by using the smart switch.

The following describes a device control method, a smart switch, and a control system provided in embodiments of this application by using an example in which a lamp is a smart home device.

FIG. 2A is a schematic of a circuit of a conventional control system according to an embodiment of this application. As shown in FIG. 2A, the conventional control system includes two single-pole double-throw switches, and the two single-pole double-throw switches are both connected in series to a lamp. The two single-pole double-throw switches may be installed in different positions, so that the same lamp can be controlled in different positions by using the two single-pole double-throw switches.

FIG. 2B is a schematic of a circuit of a smart control system according to an embodiment of this application. As shown in FIG. 2B, the conventional control system includes one smart switch and two lamps. Two relays may be integrated into the smart switch to form two independent single-pole single-throw switches, so that the lamps connected to the relays can be controlled by using the relays.

It should be noted that in a connection process of a mechanical switch and a lamp, the mechanical switch and the lamp only need to be connected in series to a live wire. In a process of replacing the mechanical switch with a smart switch, in order that the smart switch is continuously powered on, the smart switch further needs to be connected to a neutral wire (N). However, during actual application, due to impact of circuit wiring, no neutral wire is disposed in a switch bottom box in which the mechanical switch is installed, and circuit wiring needs to be adjusted for replacement with the smart switch.

Therefore, a single-live-wire smart switch that needs to be connected to only the live wire (L) gradually emerges. In other words, a single-live-wire smart switch that can operate normally when connected in series only between the live wire and the lamp gradually emerges.

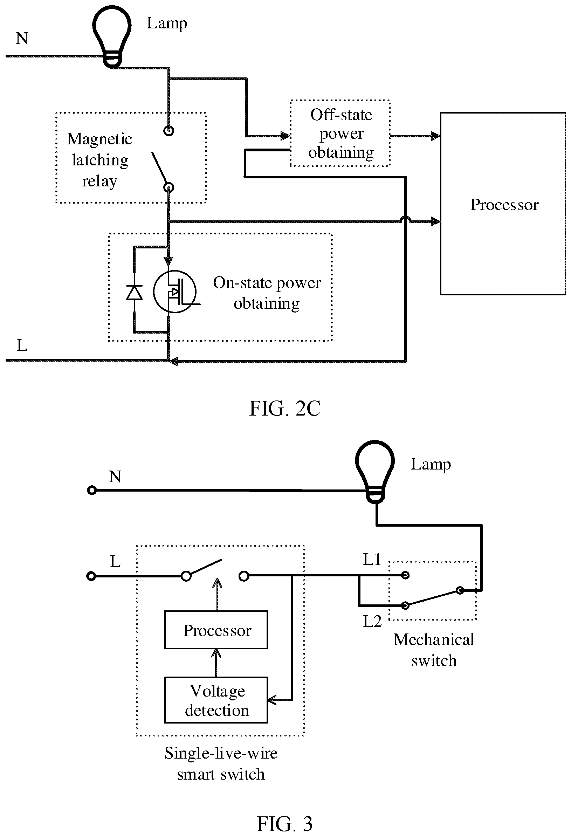

FIG. 2C is a schematic of a circuit of a smart control system according to an embodiment of this application. As shown in FIG. 2C, the conventional control system includes one single-live-wire smart switch and one lamp, and the single-live-wire smart switch is connected in series to the lamp.

The single-live-wire smart switch may include: a magnetic latching relay, an off-state power obtaining module, an on-state power obtaining module, and a processor. The single-live-wire smart switch may use electric energy provided by the off-state power obtaining module or the on-state power obtaining module. The magnetic latching relay is turned on or off by using the processor to control the lamp.

In conclusion, in a smart home scenario, a mechanical switch gradually develops into a smart switch. Based on impact of indoor circuit wiring, a single-live-wire smart switch is derived from the smart switch, so that the original mechanical switch can be conveniently replaced with the single-live-wire smart switch, and a smart home device can be controlled by using the single-live-wire smart switch.

The following further describes the single-live-wire smart switch.

FIG. 3 is a diagram of application of a single-live-wire smart switch. As shown in FIG. 3, the single-live-wire smart switch is sequentially connected in series to a mechanical switch and a lamp, and a wiring manner of the mechanical switch is adjusted, so that the single-live-wire smart switch is always in a powered-on state.

When the mechanical switch is switched between L1 and L2, a potential at the mechanical switch fluctuates. The single-live-wire smart switch may detect the fluctuation by using a voltage detection module disposed in advance. In this way, a processor controls the single-live-wire smart switch to be turned on or off, to control the lamp.

In a process of using the single-live-wire smart switch, potential fluctuation at the mechanical switch needs to be detected, and the single-live-wire smart switch is controlled based on the fluctuation to be turned on or off, to control the lamp to be in an on state or an off state. However, it takes some time for the single-live-wire smart switch to turn on or off the lamp after the foregoing operations, resulting in a problem of a delay in turning on or off the lamp.

Therefore, an embodiment of this application provides a single-live-wire smart switch. A correspondence between a lamp state and a state of a relay in the single-live-wire smart switch is set. After detecting an operation triggered by a user, the single-live-wire smart switch may perform an operation of changing a lamp state based on the correspondence and a current state of the lamp, that is, adjust a state of the relay to complete control over the lamp. This can reduce time spent in turning on or off the lamp by using the single-live-wire smart switch, and improve efficiency and accuracy of controlling the lamp by using the single-live-wire smart switch.

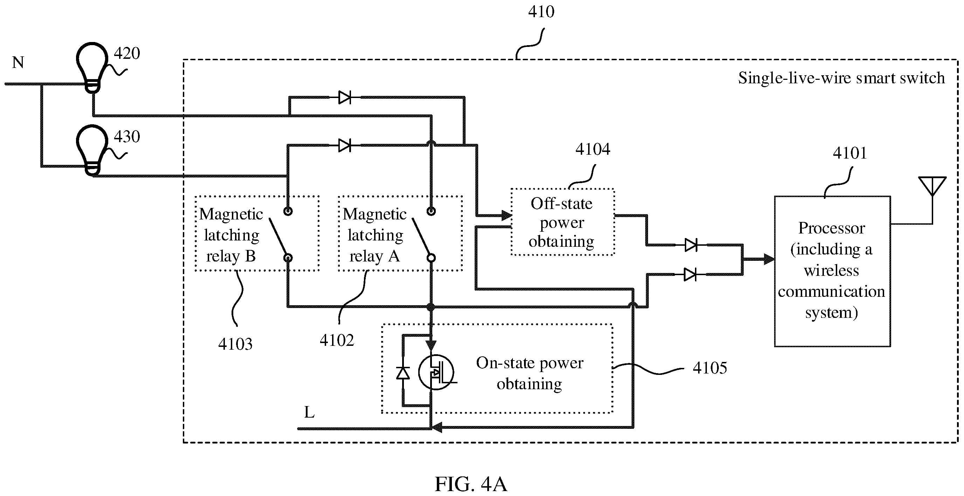

The following describes a lamp control scenario related to the single-live-wire smart switch according to an embodiment of this application. FIG. 4A is a diagram of a two-single-pole-switch scenario based on the single-live-wire smart switch according to this embodiment of this application. As shown in FIG. 4A, the two-single-pole-switch scenario may include: the single-live-wire smart switch 410, a lamp A 420, and a lamp B 430.

One end of the lamp A 420 and one end of the lamp B 430 are both connected to a neutral wire, the other end of the lamp A 420 and the other end of the lamp B 430 are both connected to the single-live-wire smart switch 410, and the single-live-wire smart switch 410 is further connected to a live wire.

Further, the single-live-wire smart switch 410 may include: a processor 4101, a magnetic latching relay A 4102, a magnetic latching relay B 4103, an off-state power obtaining module 4104, and an on-state power obtaining module 4105.

The processor 4101 may include a wireless communication system, so that the processor 4101 can access a wireless network in the current scenario. In addition, a plurality of diodes are further disposed in the single-live-wire smart switch 410 to prevent current backflow.

Specifically, as shown in FIG. 4A, the lamp A 420 may be connected to the magnetic latching relay A 4102 and the off-state power obtaining module 4104, the lamp B 430 may be connected to the magnetic latching relay B 4103 and the off-state power obtaining module 4104, the magnetic latching relay A 4102 and the magnetic latching relay B 4103 may be both connected to the on-state power obtaining module 4105, the on-state power obtaining module 4105 is further connected to a live wire, and the off-state power obtaining module 4104 and the on-state power obtaining module 4105 are both connected to the processor 4101.

The processor 4101 may control the magnetic latching relay A 4102 to be turned on or turned off, to control on/off of the lamp A 420. Similarly, the processor 4101 may control the magnetic latching relay B 4103 to be turned on or turned off, to control on/off of the lamp B 430.

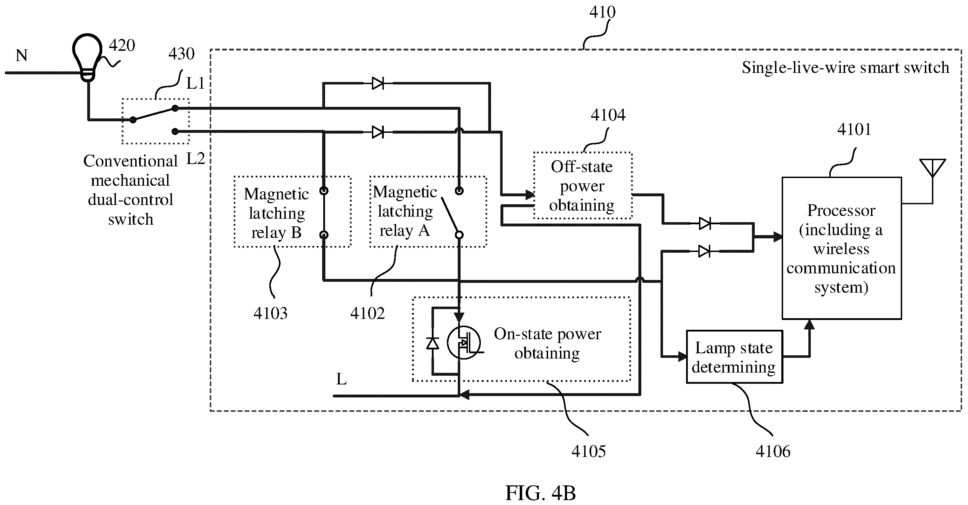

Based on the two-single-pole-switch scenario shown in FIG. 4A, an embodiment of this application further provides a single-pole double-throw switch scenario. FIG. 4B is diagram of another single-pole double-throw switch scenario based on the single-live-wire smart switch according to this embodiment of this application. As shown in FIG. 4B, the two-single-pole-switch scenario may include: the single-live-wire smart switch 410, the lamp A 420, and a mechanical switch 430. The mechanical switch 430 is a single-pole double-throw switch.

One end of the lamp A 420 is connected to the neutral wire, the other end of the lamp A 420 is connected to the mechanical switch 430, the mechanical switch 430 is connected to the single-live-wire smart switch 410, and the single-live-wire smart switch 410 is further connected to the live wire.

Further, the single-live-wire smart switch 410 may include: the processor 4101, the magnetic latching relay A 4102, the magnetic latching relay B 4103, the off-state power obtaining module 4104, the on-state power obtaining module 4105, and a lamp state determining module 4106.

The single-live-wire smart switch 410 shown in FIG. 4B is similar to the single-live-wire smart switch 410 shown in FIG. 4A. Details are not described herein again.

It should be noted that the lamp state determining module 4106 is added to the single-live-wire smart switch 410 shown in FIG. 4B. The processor 4101 may determine, based on the lamp state determining module 4106, that the lamp A 420 is currently in an on state or an off state, and then establish a correspondence between the lamp state and the relay state with reference to that the magnetic latching relay A 4102 and the magnetic latching relay B 4103 are separately in a turned-on state or a turned-off state. Then, when a triggered operation of turning on or turning off the lamp is detected, a state corresponding to the relay may be determined based on the lamp state in the correspondence, and then the processor 4101 adjusts the magnetic latching relay A 4102 and the magnetic latching relay B 4103, so that the adjusted state of the relay corresponds to the lamp state indicated by the triggered operation.

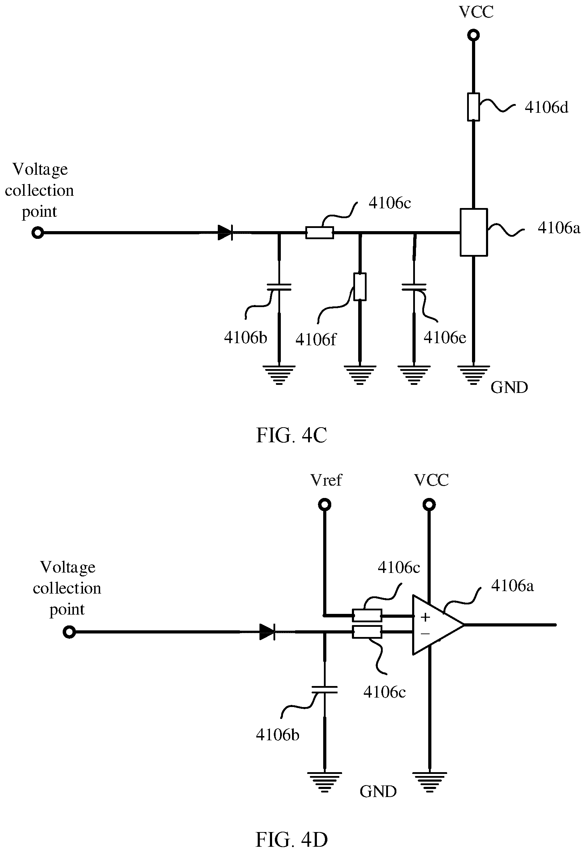

As shown in FIG. 4C, the lamp state determining module 4106 may include: a switch device 4106a, an energy storage capacitor 4106b, a voltage divider resistor 4106c, and a pull-up resistor 4106d.

The voltage divider resistor 4106c is connected in series between a control end of the switch device 4106a and a voltage collection point (the connection point connected to the on-state power obtaining module 4105 shown in FIG. 4B), the pull-up resistor 4106d is connected in series between a first end of the switch device 4106a and a power supply voltage (VCC), and a second end of the switch device 4106a is connected to a ground potential (GND).

In addition, the energy storage capacitor 4106b may be connected in series between the voltage collection point and the ground potential, and the first end of the switch device 4106a may be connected to the processor 4101 shown in FIG. 4B.

In an operating process of the single-live-wire smart switch 410, the single-live-wire smart switch 410 and the lamp A 420 are both connected to an alternating current power grid, and a direction of a current flowing through the single-live-wire smart switch 410 and the lamp A 420 continuously changes with a cycle of the alternating current.

If the lamp A 420 is in an on state and the alternating current flows from the neutral wire to the live wire, a voltage gradually increases, and the energy storage capacitor 4106b is charged in the increasing process, so that the control end of the switch device 4106a is maintained at a high potential. After the voltage increases to a rated voltage of the single-live-wire smart switch 410, the single-live-wire smart switch 410 may control the switch device in the on-state power obtaining module 4105 to be turned on, and the alternating current reaches the live wire through the switch device 4106a, and does not charge the energy storage capacitor 4106b anymore. However, the energy storage capacitor 4106b may continuously discharge, and maintain the control end of the switch device 4106a at the high potential until a next cycle of the alternating current is reached.

It should be noted that the switch device 4106a may be a bipolar transistor, may be a metal-oxide-semiconductor field-effect transistor (metal-oxide-semiconductor field-effect transistor, MOSFET), or may be another device having a switch function. The switch device 4106a is not limited in this embodiment of this application.

For example, when the switch device 4106a is a bipolar transistor, the control end of the switch device 4106a may be a base of the bipolar transistor, the first end of the switch device 4106a may be a collector of the bipolar transistor, and the second end of the switch device 4106a may be an emitter of the bipolar transistor.

Alternatively, when the switch device 4106a is an MOSFET, the control end of the switch device 4106a may be a gate of the MOSFET, the first end of the switch device 4106a may be a drain or a source of the MOSFET, and the second end of the switch device 4106a may be a source or a drain of the MOSFET.

In addition, the lamp state determining module 4106 may further include: a filter capacitor 4106e and a filter resistor 4106f. The filter capacitor 4106e and the filter resistor 4106f may be both connected in series between the control end of the switch device 4106a and the ground potential, so that the filter capacitor 4106e and the filter resistor 4106f may filter a spike, a glitch, noise, and the like in the alternating current.

In addition, during actual application, the lamp state determining module 4106 may alternatively include another component. As shown in FIG. 4D, the lamp state determining module 4106 may include: a comparison module 4106a, an energy storage capacitor 4106b, and voltage divider resistors 4106c.

A positive input end of the comparison module 4106a is connected to a reference voltage, a negative input end of the comparison module 4106a is connected to the voltage collection point (the connection point connected to the on-state power obtaining module 4105 shown in FIG. 4B), and an output end of the comparison module 4106a is connected to the processor 4101 shown in FIG. 4B.

In addition, the voltage divider resistors 4106c may be respectively connected in series between the positive input end of the comparison module 4106a and the reference voltage (Vref) and between the negative input end of the comparison module 4106a and the voltage collection point. In addition, the energy storage capacitor 4106b is connected in series between the voltage collection point and the ground potential (GND).

An operating process of the lamp state determining module 4106 shown in FIG. 4D is similar to the operating process of the lamp state determining module 4106 shown in FIG. 4C, and is not described herein again.

It should be noted that in an operating process, the comparison module 4106a may compare a potential of the voltage collection point with a reference potential. If the potential of the voltage collection point is less than the reference potential, a signal output by the comparison module 4106a may indicate that the lamp A 420 is in the off state; or if the potential of the voltage collection point is greater than or equal to the reference potential, a signal output by the comparison module 4106a may indicate that the lamp A 420 is in the on state.

The comparison module 4106a may be a comparator, may be a comparison circuit including a plurality of components, or may be another circuit module having a comparison function. Embodiments of this application impose no limitation on the comparison module 4106a.

In addition, in the foregoing process of adjusting the lamp state, the lamp A 420 may be controlled by using the mechanical switch 430, the lamp may be controlled by using the single-live-wire smart switch 410, or the lamp A 420 may be controlled by using a terminal device wirelessly connected to the single-live-wire smart switch 410 based on an application installed on the terminal device. A manner of controlling the lamp state is not limited in embodiments of this application.

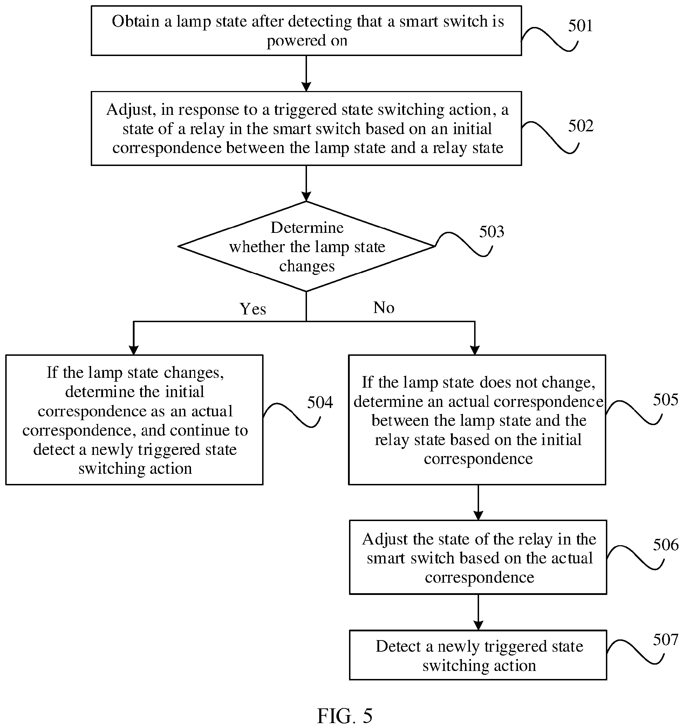

FIG. 5 is a schematic flowchart of a device control method according to an embodiment of this application. As an example rather than a limitation, the method may be applied to the single-live-wire smart switch (referred to as a smart switch). For ease of description, in this embodiment of this application, descriptions are provided by using an example in which a lamp is a smart home device. With reference to FIG. 5, the method includes the following steps.

Step 501: Obtain a lamp state after detecting that the smart switch is powered on.

In a smart home scenario, the smart switch needs to be connected to the lamp through circuit wiring disposed in advance in the smart home scenario, to control the lamp by using the smart switch. However, in a connection process of the smart switch and the lamp, power supply needs to be cut off in the smart home scenario first, to ensure safety of connecting the smart switch.

Correspondingly, after the smart switch is connected to the lamp, power supply may be restored in the smart home scenario, and power may be supplied to the smart switch. After detecting power-on, the smart switch may determine the lamp state by using a lamp state determining module disposed in advance.

The lamp state may be an on state or an off state.

For example, the smart switch may detect, by using the lamp state determining module, a potential at an on-state power obtaining module. If the detected potential is at a high level, it may be determined that the lamp state is the on state, which indicates that the lamp performs illumination. If the detected potential is at a low level, it may be determined that the lamp state is the off state, which indicates that the lamp does not perform illumination.

Step 502: Adjust, in response to a triggered state switching action, a state of a relay in the smart switch based on an initial correspondence between the lamp state and a relay state.

The state switching action is an action that is triggered by a user and that is used to switch the lamp state. In addition, the state switching action may be triggered for the smart switch, may be triggered for a mechanical switch, or may be triggered for an application installed on a terminal device. This is not limited in this embodiment of this application.

After power is supplied to the smart switch, the smart switch may detect the state switching action triggered by the user. If it is detected that the user triggers the state switching action for the smart switch, the smart switch may trigger state switching of the smart switch in response to the state switching action, and adjust a state of each relay in the smart switch based on the preset initial correspondence between the lamp state and the relay state, to switch the lamp state.

Specifically, after detecting the triggered state switching action, the smart switch may trigger the state switching of the smart switch, and determine, based on the lamp state determined in step 501, a target state opposite to the lamp state. Then, the smart switch may obtain the initial correspondence between the lamp state and the relay state, search the initial correspondence for a relay state corresponding to the target state, and adjust the relay of the smart switch based on the found relay state, so that the adjusted state of the relay is consistent with the relay state corresponding to the target state.

It should be noted that the single-live-wire smart switch including two magnetic latching relays shown in FIG. 4B is used as an example. In a process of obtaining the initial correspondence, the smart switch may establish a correspondence between the lamp state and a default state of the relay based on the lamp state obtained in step 501, that is, establish the initial correspondence.

Optionally, the smart switch may obtain a preset default state of each relay. Then, the smart switch may establish, based on the lamp state of the lamp, the first mapping relationship between the lamp state and the default state of each relay, and establish, based on a target state of the lamp, a second mapping relationship between the target state and a non-default state of each relay. Finally, the smart switch may obtain the initial correspondence by combining the first mapping relationship and the second mapping relationship.

The default state of the relay may be a turned-on state or a turned-off state, and the non-default state is a relay state opposite to the default state.

For example, default states of the two magnetic latching relays may be 1A2B, where numbers "1" and "2" respectively represent sequence numbers corresponding to the two magnetic latching relays, a letter "A" indicates that the magnetic latching relay is in a turned-on state, and a letter "B" indicates that the magnetic latching relay is in a turned-off state. In this way, 1A2B may indicate that the No. 1 magnetic latching relay (for example, the magnetic latching relay A shown in FIG. 4B) is in the turned-on state, and the No. 2 magnetic latching relay (for example, the magnetic latching relay B shown in FIG. 4B) is in the turned-off state.

If the smart switch determines, in step 501, that the lamp is in the on state, the smart switch may establish an initial correspondence between the on state and 1A2B, and establish an initial correspondence between the turned-off state and 1B2A. Similarly, if the smart switch determines, in step 501, that the lamp is in the off state, the smart switch may establish an initial correspondence between the off state and 1A2B, and establish an initial correspondence between the on state and 1B2A.

Correspondingly, if the smart switch determines, in step 501, that the lamp is in the on state, and the initial correspondence is that the on state corresponds to 1A2B, and the off state corresponds to 1B2A, after detecting the triggered state switching action, the smart switch may determine the off state as the target state of the lamp, and adjust the two magnetic latching relays of the smart switch based on 1B2A corresponding to the off state in the initial correspondence, so that the two magnetic latching relays are in the 1B2A state after adjustment.

Step 503: Determine whether the lamp state changes.

After adjusting the relay, the smart switch may obtain a lamp state again, to determine whether the lamp state changes after the state of the relay in the smart switch is adjusted in step 502, that is, determine whether the adjustment of the state of the relay is effective, so that in a subsequent step, an actual correspondence between the lamp state and the relay state may be determined based on a determining result.

A process in which the smart switch obtains the lamp state in step 503 is similar to the process in which the smart switch obtains the lamp state in step 501. Details are not described herein again.

Specifically, after the smart switch obtains the lamp state again, the smart switch may compare the lamp state obtained again with the lamp state obtained in step 501, to determine whether the lamp state changes. If the lamp state changes, it indicates that the smart switch effectively adjusts the state of the relay, and the smart switch may perform step 504; or if the lamp state does not change, it indicates that the smart switch ineffectively adjusts the state of the relay, and the smart switch may perform step 505.

For example, the on state of the lamp may be represented by "1", and the off state of the lamp may be represented by "0". If the lamp state obtained by the smart switch in step 501 is 0, and the lamp state obtained again in step 503 is 1, after the smart switch compares the lamp states obtained in two times, it may be determined that the lamp state changes, and the smart switch adjusts the state of the relay effectively.

Step 504: If the lamp state changes, determine the initial correspondence as an actual correspondence, and continue to detect a newly triggered state switching action.

Corresponding to step 503, after the smart switch determines that the lamp state changes, the smart switch may determine that the initial correspondence is accurate, and may determine the initial correspondence as the actual correspondence between the lamp state and the relay state without adjusting the initial correspondence, so that the smart switch can adjust the state of the relay based on the actual correspondence, and control the lamp.

It should be noted that during actual application, the lamp may be controlled by using the smart switch, may be controlled by using an application installed on the terminal device, or may be controlled by using a mechanical switch. Therefore, in a process of continuing to detect the state switching action, if the smart switch detects that a state of the mechanical switch changes, the smart switch may also correspondingly adjust the state of the relay, to cooperate with the mechanical switch to control the lamp. Correspondingly, the smart switch may further update an actual correspondence between the lamp state and the relay state.

Specifically, the smart switch may monitor a potential change at the mechanical switch. If it is detected that a potential at the mechanical switch changes, it may be determined that the state of the mechanical switch changes, and the user triggers, for the mechanical switch, a state switching action of turning on or off the lamp.

Correspondingly, the smart switch may adjust the state of the relay based on the determined actual correspondence, to cooperate with the mechanical switch to adjust the lamp state. In addition, the smart switch further needs to update the actual correspondence, so that after the state of the mechanical switch changes, the smart switch may continue to control the lamp based on the updated actual correspondence.

For example, corresponding to the example in step 502, if the determined actual correspondence between the lamp state and the relay state includes that the on state corresponds to 1A2B and the off state corresponds to 1B2A, after detecting that the state of the mechanical switch changes, the smart switch may adjust the states of the two relays, and update the actual correspondence, to obtain an updated actual correspondence. The actual correspondence includes that the on state corresponds to 1B2A, and the off state corresponds to 1A2B.

Step 505: If the lamp state does not change, determine an actual correspondence between the lamp state and the relay state based on the initial correspondence.

Contrary to step 504, if the smart switch determines that the lamp state does not change, it indicates that the obtained initial correspondence is incorrect, and the initial correspondence needs to be adjusted to obtain the actual correspondence between the lamp state and the relay state, so that the smart switch can control the lamp based on the actual correspondence.

Correspondingly, in the process of adjusting the initial correspondence, if the smart switch includes two relays, the smart switch may exchange the relay state corresponding to the on state of the lamp and the relay state corresponding to the off state of the lamp, to obtain the actual correspondence between the lamp state and the relay state.

Optionally, the smart switch may replace a device state corresponding to a default state of each relay in the initial correspondence with a target state of the lamp, and replace a target state corresponding to a non-default state of each relay in the initial correspondence with a lamp state of the lamp, to obtain the actual correspondence between the lamp state and the relay state.

For example, corresponding to the example in step 502, if the initial correspondence between the lamp state and the relay state includes that the on state corresponds to 1A2B, and the off state corresponds to 1B2A, and the lamp state does not change after step 502 is performed, the smart switch may adjust, based on the initial correspondence, the on state to correspond to 1B2A and the off state to correspond to 1A2B, to obtain the actual correspondence.

It should be noted that during actual application, after the state of the relay in the smart switch is adjusted, if the lamp state does not change, it indicates that the state of the relay in the smart switch does not actually change in the process in which step 502 is performed, but an original state is maintained. In other words, the state that the smart switch needs the relay to reach in step 502 is a current state of the relay, so that the current state of the relay can be determined.

Step 506: Adjust the state of the relay in the smart switch based on the actual correspondence.

A process of adjusting the relay in step 506 is similar to the process of adjusting the relay in step 502. Details are not described herein again.

It should be noted that during actual application, the smart switch may adjust the state of each relay in the smart switch in different sequences. Therefore, in a process in which the smart switch adjusts the state of the relay again, the smart switch may preferentially adjust the relay that can change the lamp state.

Optionally, the smart switch may obtain, based on the actual correspondence, a plurality of target relay states matching the target state of the lamp, and then adjust each relay based on each target relay state.

The target relay state is used to indicate a current state corresponding to each relay in the smart switch after the lamp is switched to the target state. In addition, each target relay state is in a one-to-one correspondence with each relay.

In a process of adjusting each relay, the smart switch may select a preferred relay state from the plurality of target relay states based on the target state, and adjust, based on the preferred relay state, a preferred relay corresponding to the preferred relay state. Then, a relay other than the preferred relay in the plurality of relays is adjusted based on a target relay state other than the preferred relay state in the plurality of target relay states.

The preferred relay state is used to adjust the lamp to switch to the target state, and a relay corresponding to the preferred relay state is the preferred relay.

Specifically, the smart switch may determine the target state of the lamp in step 502 based on the current state of the relay and the actual correspondence, and then search the actual correspondence for the target relay state corresponding to each relay corresponding to the target state.

If the smart switch includes two magnetic latching relays, the smart switch may determine, based on a target relay state corresponding to each magnetic latching relay, that one relay of the two magnetic latching relays needs to be adjusted to the turned-on state, and the other relay of the two magnetic latching relays needs to be adjusted to the turned-off state.

If the target state of the lamp is the on state, it indicates that the preferred relay and the preferred relay state of the two magnetic latching relays need to be determined first based on current states of the two magnetic latching relays, and then the preferred relay is adjusted to the preferred relay state, that is, is adjusted to the turned-on state, so that the preferred relay and the lamp form a circuit path, to turn on the lamp. Therefore, the smart switch may first determine the preferred relay, then adjust the preferred relay from the turned-off state to the turned-on state, and then adjust the other relay from the turned-on state to the turned-off state, to quickly turn on the lamp and reduce delay time of the smart switch.

Similarly, if the target state of the lamp is the off state, the preferred relay and the preferred relay state of the two magnetic latching relays also need to be determined first based on the current states of the two magnetic latching relays, and then the preferred relay is adjusted to the preferred relay state, that is, is adjusted to the turned-off state, so that the preferred relay and the lamp form an open circuit, to turn off the lamp. Therefore, the smart switch may first determine the preferred relay, then adjust the preferred relay from the turned-on state to the turned-off state, and then adjust the other relay from the turned-off state to the turned-on state, to quickly turn off the lamp and reduce delay time of the smart switch.

For example, corresponding to the example in step 505, the actual correspondence between the lamp state and the relay state includes that the on state corresponds to 1B2A and the off state corresponds to 1A2B. If the triggered state switching action indicates to turn on the lamp, a target state of the lamp is the on state, a target relay state corresponding to the target state is 1B2A, and the smart switch may first determine that the turned-on state is the preferred relay state, and determine that the No. 2 magnetic latching relay is the preferred relay. Then, the No. 2 magnetic latching relay may be adjusted from the turned-off state to the turned-on state, to form a relay state of 1A2A, and then the No. 1 magnetic latching relay is adjusted from the turned-on state to the turned-off state, so that the two relays reach the state of 1B2A.

Similarly, if the triggered state switching action indicates to turn off the lamp, a target state of the lamp is the turned-off state, a relay state corresponding to the target state is 1A2B, and the smart switch may first determine that the turned-off state is the preferred relay state, and determine that the No. 2 magnetic latching relay is the preferred relay. Then, the No. 2 magnetic latching relay may be adjusted from the turned-on state to the turned-off state, to form a relay state of 1B2B, and then the No. 1 magnetic latching relay is adjusted from the turned-off state to the turned-on state, so that the two relays reach the state of 1A2B.

It should be noted that during actual application, in a process of adjusting states of the two relays, after adjusting the state of one relay, the smart switch may adjust the state of the other relay after a specific time period, to improve reliability of adjusting the state of the relay. For example, after adjusting the state of one relay, the smart switch may adjust the state of the other relay after millisecond-level duration (for example, 100 milliseconds to 200 milliseconds).

Step 507: Detect a newly triggered state switching action.

A process of detecting the newly triggered state switching action in step 507 is similar to the process of detecting the newly triggered state switching action in step 504. Details are not described herein again.

It should be noted that during actual application, in a smart home scenario, a smart switch may be installed, or a power failure may occur in the smart home scenario, and power needs to be supplied to the smart switch again. In this way, the smart switch may perform step 501 to step 507 again, to control a smart home device by using the smart switch.

In conclusion, by using the device control method provided in this embodiment of this application, the lamp state is obtained, the state of the relay in the smart switch is adjusted based on the triggered state switching action and the initial correspondence between the lamp state and the relay state, and then the lamp state is obtained again. Based on the lamp states obtained in two times, the actual correspondence between the lamp state and the relay state is determined, so that the lamp is controlled based on the actual correspondence. This can reduce time spent in controlling the lamp by using the smart switch, and improve efficiency and accuracy of controlling the lamp by using the smart switch.

In addition, in a process of adjusting the relay state, the smart switch may determine, based on a state of a relay corresponding to a target state in the actual correspondence and a target state of the lamp, a sequence of adjusting the state of the relay, and then adjust the state of the relay based on the determined sequence. This can further reduce time required for switching the lamp to the target state, and improve efficiency of controlling the lamp.

It should be understood that sequence numbers of the steps in the foregoing embodiments do not mean a sequence for performing. The sequence for performing the processes should be determined based on functions and internal logic of the processes, and should not constitute any limitation on implementation processes of embodiments of this application.

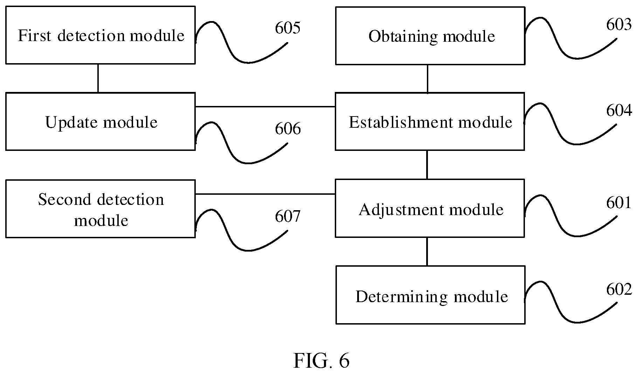

Corresponding to the device control method in the foregoing embodiments, FIG. 6 is a block diagram of a structure of a device control apparatus according to an embodiment of this application. For ease of description, only parts related to embodiments of this application are shown.

As shown in FIG. 6, the apparatus includes:
an adjustment module 601, configured to adjust, in response to state switching triggered for a smart switch, a relay state of each relay in the smart switch based on an initial correspondence between a device state and a relay state;
a determining module 602, configured to: if a device state of an electrical device does not change, determine an actual correspondence between the device state and the relay state based on the initial correspondence;
the adjustment module 601 is further configured to adjust the relay state of each relay in the smart switch based on the actual correspondence; and
the determining module 602 is further configured to: if a device state of an electrical device changes, determine the initial correspondence as the actual correspondence between the device state and the relay state.

Optionally, the apparatus further includes:
an obtaining module 603, configured to obtain the device state of the electrical device after detecting that the smart switch is powered on; and
an establishment module 604, configured to establish the initial correspondence between the device state and the relay state.

Optionally, the device state is an on state or an off state, and the relay state is a turned-on state or a turned-off state; and
the establishment module 604 is specifically configured to: obtain a preset default state of each relay, where the default state is a turned-on state or a turned-off state; establish, based on the device state of the electrical device, a first mapping relationship between the device state and the default state of each relay; establish, based on a target state of the electrical device, a second mapping relationship between the target state and a non-default state of each relay, where the non-default state is a relay state opposite to the default state, and the target state is a state that is of the electrical device and that is opposite to the device state; and obtain the initial correspondence by combining the first mapping relationship and the second mapping relationship.

Optionally, the device state is an on state or an off state, and the relay state is a turned-on state or a turned-off state; and
the determining module 602 is specifically configured to: replace a device state corresponding to a default state of each relay in the initial correspondence with a target state of the electrical device, and replace a target state corresponding to a non-default state of each relay in the initial correspondence with the device state of the electrical device, to obtain the actual correspondence, where
the non-default state is a relay state opposite to the default state, and the target state is a state that is of the electrical device and that is opposite to the device state.

Optionally, the adjustment module 601 is specifically configured to: determine the target state of the electrical device, where the target state is the state that is of the electrical device and that is opposite to the device state; obtain, based on the actual correspondence, a plurality of target relay states matching the target state, where each target relay state is in a one-to-one correspondence with each relay; and adjust each relay based on each target relay state.

Optionally, the adjustment module 601 is further specifically configured to: select a preferred relay state from the plurality of target relay states based on the target state, where the preferred relay state is used to adjust the electrical device to switch to the target state; adjust, based on the preferred relay state, a preferred relay corresponding to the preferred relay state; and adjust a relay other than the preferred relay in the plurality of relays based on a target relay state other than the preferred relay state in the plurality of target relay states.

Optionally, the smart switch and the electrical device are further connected to a mechanical switch, and the apparatus further includes:
a first detection module 605, configured to detect state switching triggered for the mechanical switch; and
an update module 606, configured to update the actual correspondence in response to the state switching triggered for the mechanical switch.

Optionally, the apparatus further includes:
a second detection module 607, configured to detect again state switching triggered for the mechanical switch or the smart switch; and
the adjustment module 601, further configured to adjust, in response to the state switching triggered for the mechanical switch or the smart switch, the relay state of each relay in the smart switch based on the actual correspondence.

In conclusion, by using the device control apparatus provided in this embodiment of this application, the lamp state is obtained, the state of the relay in the smart switch is adjusted based on the triggered state switching action and the initial correspondence between the lamp state and the relay state, and then the lamp state is obtained again. Based on the lamp states obtained in two times, the actual correspondence between the lamp state and the relay state is determined, so that the lamp is controlled based on the actual correspondence. This can reduce time spent in controlling the lamp by using the smart switch, and improve efficiency and accuracy of controlling the lamp by using the smart switch.

A person skilled in the art may clearly understand that for the purpose of convenient and brief description, division into the foregoing functional units or modules is merely used as an example for description. During actual application, the foregoing functions can be allocated to different functional units or modules for implementation based on a requirement. In other words, an inner structure of the apparatus is divided into different functional units or modules to implement all or some of the functions described above. The functional units or modules in embodiments may be integrated into one processing unit, each of the units may exist alone physically, or two or more units are integrated into one unit. The integrated unit may be implemented in a form of hardware, or may be implemented in a form of a software functional unit. In addition, specific names of the functional units and modules are merely for ease of distinguishing between the functional units and modules, but are not intended to limit the protection scope of this application. For a detailed operating process of the foregoing units or modules in the foregoing system, refer to a corresponding process in the foregoing method embodiments. Details are not described herein again.

In the foregoing embodiments, the descriptions of each embodiment have respective focuses. For a part of an embodiment that is not described or explained in detail, refer to related descriptions of another embodiment.

A person of ordinary skill in the art may be aware that, in combination with the examples described in embodiments disclosed in this specification, units and algorithm steps may be implemented by electronic hardware or a combination of computer software and electronic hardware. Whether the functions are performed by hardware or software depends on particular applications and design constraints of the technical solutions. A person skilled in the art may use different methods to implement the described functions for each particular application, but it should not be considered that the implementation goes beyond the scope of this application.

In embodiments provided in this application, it should be understood that the disclosed apparatus and method may be implemented in another manner. For example, the described system embodiment is merely an example. For example, division into the units or modules is merely logical function division and may be other division in actual implementation. For example, a plurality of units or components may be combined or integrated into another system, or some features may be ignored or not performed. In addition, the displayed or discussed mutual coupling or direct coupling or communication connections may be implemented through some interfaces. The indirect coupling or communication connections between the apparatuses or units may be implemented in electrical, mechanical, or another form.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of embodiments.

In addition, functional units in embodiments of this application may be integrated into one processing unit, each of the units may exist alone physically, or two or more units may be integrated into one unit. The integrated unit may be implemented in a form of hardware, or may be implemented in a form of a software functional unit.

When the integrated unit is implemented in the form of the software functional unit and sold or used as an independent product, the integrated unit may be stored in a computer-readable storage medium. Based on such an understanding, in this application, all or some of the procedures of the methods in the foregoing embodiments may be implemented by a computer program instructing related hardware. The computer program may be stored in a computer-readable storage medium. When the computer program is executed by a processor, the steps in the method embodiments can be implemented. The computer program includes computer program code. The computer program code may be in a form of source code, object code, an executable file, in an intermediate form, or the like. The computer-readable medium may include at least any entity or apparatus that can carry the computer program code to a smart switch, a recording medium, a computer memory, a read-only memory (ROM, read-only memory), a random access memory (RAM, random access memory), an electrical carrier signal, a telecommunications signal, and a software distribution medium, for example, a USB flash drive, a removable hard disk, a magnetic disk, or an optical disc. In some jurisdictions, the computer-readable medium cannot be an electrical carrier signal or a telecommunications signal according to legislation and patent practices.

In conclusion, it should be noted that the foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A device control method, applied to a smart switch, wherein the smart switch is connected to an electrical device, the smart switch comprises a plurality of relays, and the method comprises:
adjusting, in response to state switching triggered for the smart switch, a relay state of each relay in the smart switch based on an initial correspondence between a device state and a relay state; and
if a device state of the electrical device does not change, determining an actual correspondence between the device state and the relay state based on the initial correspondence, and
adjusting the relay state of each relay in the smart switch based on the actual correspondence; or
if a device state of the electrical device changes, determining the initial correspondence as an actual correspondence between the device state and the relay state.

2. The method according to claim 1, wherein before the adjusting, in response to state switching triggered for the smart switch, a relay state of each relay in the smart switch based on an initial correspondence between a device state and a relay state, the method further comprises:
after detecting that the smart switch is powered on, obtaining the device state of the electrical device; and
establishing the initial correspondence between the device state and the relay state.

3. The method according to claim 2, wherein the device state is an on state or an off state, and the relay state is a turned-on state or a turned-off state; and
the establishing the initial correspondence between the device state and the relay state comprises:
obtaining a preset default state of each relay, wherein the default state is a turned-on state or a turned-off state;
establishing, based on the device state of the electrical device, a first mapping relationship between the device state and the default state of each relay;
establishing, based on a target state of the electrical device, a second mapping relationship between the target state and a non-default state of each relay, wherein the non-default state is a relay state opposite to the default state, and the target state is a state that is of the electrical device and that is opposite to the device state; and
obtaining the initial correspondence by combining the first mapping relationship and the second mapping relationship.

4. The method according to claim 1, wherein the device state is an on state or an off state, and the relay state is a turned-on state or a turned-off state; and
the determining an actual correspondence between the device state and the relay state based on the initial correspondence comprises:
replacing, with a target state of the electrical device, a device state corresponding to a default state of each relay in the initial correspondence, and replacing, with the device state of the electrical device, a target state corresponding to a non-default state of each relay in the initial correspondence, to obtain the actual correspondence, wherein
the non-default state is a relay state opposite to the default state, and the target state is a state that is of the electrical device and that is opposite to the device state.

5. The method according to any one of claims 1 to 4, wherein the adjusting the relay state of each relay in the smart switch based on the actual correspondence comprises:
determining the target state of the electrical device, wherein the target state is the state that is of the electrical device and that is opposite to the device state;
obtaining, based on the actual correspondence, a plurality of target relay states matching the target state, wherein each target relay state is in a one-to-one correspondence with each relay; and
adjusting each relay based on each target relay state.

6. The method according to claim 5, wherein the adjusting each relay based on each target relay state comprises:
selecting a preferred relay state from the plurality of target relay states based on the target state, wherein the preferred relay state is used to adjust the electrical device to switch to the target state;
adjusting, based on the preferred relay state, a preferred relay corresponding to the preferred relay state; and
adjusting a relay other than the preferred relay in the plurality of relays based on a target relay state other than the preferred relay state in the plurality of target relay states.

7. The method according to any one of claims 1 to 6, wherein the smart switch and the electrical device are further connected to a mechanical switch, and the method comprises:
detecting state switching triggered for the mechanical switch; and
updating the actual correspondence in response to the state switching triggered for the mechanical switch.

8. The method according to any one of claims 1 to 7, wherein after the adjusting the relay state of each relay in the smart switch based on the actual correspondence, the method further comprises:
detecting again state switching triggered for the mechanical switch or the smart switch; and
adjusting, in response to the state switching triggered for the mechanical switch or the smart switch, the relay state of each relay in the smart switch based on the actual correspondence.

9. A smart switch, wherein the smart switch comprises: a processor, a device state determining module, a plurality of magnetic latching relays, an on-state power obtaining module, and an off-state power obtaining module;
the processor is connected to the device state determining module, the on-state power obtaining module, and the off-state power obtaining module, the plurality of magnetic latching relays are all connected to the on-state power obtaining module and the off-state power obtaining module, the device state determining module is further connected to a voltage collection point, and the voltage collection point is a potential between the on-state power obtaining module and the plurality of magnetic latching relays; and
the device state determining module is configured to determine a device state of an electrical device connected to the smart switch, and the processor is configured to adjust relay states of the plurality of magnetic latching relays based on the device state determined by the device state determining module.

10. The smart switch according to claim 9, wherein the device state determining module comprises: a switch device, an energy storage capacitor, a voltage divider resistor, and a pull-up resistor; and
the voltage divider resistor is connected in series between a control end of the switch device and the voltage collection point, the pull-up resistor is connected in series between a first end of the switch device and a power supply voltage, the energy storage capacitor is connected in series between the voltage collection point and a ground potential, the first end of the switch device is connected to the processor, and a second end of the switch device is connected to the ground potential.

11. The smart switch according to claim 9, wherein the device state determining module comprises: a comparison module, an energy storage capacitor, and voltage divider resistors;
a positive input end of the comparison module is connected to a reference voltage, a negative input end of the comparison module is connected to the voltage collection point, and an output end of the comparison module is connected to the processor;
the voltage divider resistors are respectively connected in series between the positive input end of the comparison module and the reference voltage and between the negative input end of the comparison module and the voltage collection point; and
the energy storage capacitor is connected in series between the voltage collection point and a ground potential.

12. A control system, wherein the control system comprises: an electrical device, a smart switch, and a mechanical switch; and
the electrical device is connected in series to the smart switch and the mechanical switch, the mechanical switch is configured to adjust a device state of the electrical device, and the smart switch is configured to adjust the device state of the electrical device according to the device control method according to any one of claims 1 to 8.

13. A computer-readable storage medium, wherein the computer-readable storage medium stores a computer program, and when the computer program is executed by a processor, the device control method according to any one of claims 1 to 8 is implemented.

14. A chip system, wherein the chip system comprises a memory and a processor, and the processor executes a computer program stored in the memory, to implement the device control method according to any one of claims 1 to 8.
